# EUROPEAN PATENT APPLICATION

(11) **EP 2 525 277 A2**
(43) Date of publication of application: **21.11.2012**
(21) Application number: 12166795.0
(22) Date of filing: 04.05.2012
(51) Int. Cl.: G06F 3/041

(54) **Apparatus, and associated method, for testing a touch sensing device**

(30) Priority: 16.05.2011 US 201161486620 P
(71) Applicant: Research In Motion Limited, Waterloo, ON N2L 3W8 (CA)
(72) Inventor: Pereverzev, Stanislav, Cupertino, CA 95014 (US); Golovchenko, Mykola, Cupertino, CA 95014 (US); Solven, Derek Raymond, San Jose CA 95134 (US)
(74) Representative: Greenaway, Martin William

(57) **Abstract**

An apparatus, and an associated method, tests for an anomaly, such as an open circuit or a short circuit, at a touch sensing device. An electrical characteristic sensor senses an electrical characteristic at an electrode of the touch sensing device. Responsive to the sensed electrical characteristic, a determination is made by a determiner as to whether a short or open circuit or other anomaly exists at the touch sensing device.

## Description

### Cross-Reference of Related Application

The present application claims the benefit of U.S. Provisional Application serial no. 61/486,620 filed on May 16, 2011, the contents of which are incorporated herein by reference.

### Background

The present disclosure relates generally to a manner by which to test a touch sensing device, such as a touch screen device. More particularly, the present disclosure relates to an apparatus and an associated method, by which to test for an anomaly, such as a short or open circuit between electrodes of the touch sensing device.

Testing is performed during manufacturing and assembly of the touch sensing device. Or, testing is performed as part of diagnostic operations of an electronic device at which the touch sensing device is embodied. An open or short circuit or other anomaly is readily detected and alerted, thereby to facilitate remedial action, if needed.

A touch sensing device typically incorporates a capacitive touch screen including an array of conductive electrodes, such as indium tin oxide, disposed upon one or more layers of a nonconductive, such as glass or plastic, material. The electrodes are typically arranged to form a grid, and the electrodes are connected to a capacitive sensing chip, implemented, e.g., as an ASIC.

A touching input applied to a surface in proximity to an electrode of a capacitive touch screen distorts the electrostatic field of the surface. The distortion is measureable as a change in capacitance. The position at which the touch input is applied is able to be discerned, and the position at which the input is entered is determinative of the input.

Use of touch sensing devices as part of a user interface is advantageous as a user is able to interact directly to a display output. Additionally, an input is able to be entered without requiring use of an intermediate device. Additionally, the display, and associated inputs, are changeable, permitting multiple screens successively to be displayed and multiple inputs entered by way of the same touch sensing device.

Fabrication and assembly of a touch sensing device is a multi-stage process, requiring that electrodes be precisely positioned and electrically isolated from other electrodes of a grid of electrodes. Testing of a fabricated or otherwise assembled touch sensing device is undertaken to confirm that the touch sensing device has been fabricated or assembled correctly. Conventional testing is typically limited to a manual check of the touch sensing device. Manual checking is time-consumptive and is not amenable for production-line assembly operations, An improved manner by which to test or perform diagnostics upon a touch sensing device is therefore needed.

It is in light of this background information related to touch sensing devices that the significant improvements of the present disclosure have evolved.

### Brief Description of the Drawings

Figure 1 illustrates a functional block, partial plan view of a touch screen device exemplary of a touch screen device that is tested pursuance to an implementation of the present disclosure.

Figure 2 illustrates a representation of the touch screen device shown in Figure 1 having a short circuit formed between adjacent electrodes of a grid of electrodes of the touch screen device.

Figure 3 illustrates a representation, similar to that shown in Figure 2, but here showing an anomaly forming an open circuit that is also detectable pursuant to testing performed by an implementation of the present disclosure.

Figure 4 illustrates a representation, similar to those shown in Figures 2-3, but here showing an anomaly forming a short circuit that is detectable pursuant to testing performed by an implementation of the present disclosure.

Figure 5 illustrates a representation of resistance testing performed pursuance to another implementation of the present disclosure.

Figure 6 illustrates another representation, that shown in Figure 5, but of another implementation of resistance testing performed pursuance to an implementation of the present disclosure.

Figure 7 illustrates the touch screen device shown in the previous figures implemented at an electronic device.

Figure 8 illustrates a process diagram representative of the process of operation of an implementation of the present disclosure.

Figure 9 illustrates a method flow diagram representative of the method of operation of an implementation of the present disclosure.

### Detailed Description

The present disclosure, accordingly, advantageously provides an apparatus, and an associated method, by which to test a touch sensing device, such as a touch screen device.

Through operation of an implementation of the present disclosure, a manner is provided by to test for an anomaly, such as a short, or open circuit between electrodes of the touch sensing device.

In one aspect of the present disclosure, the testing is performed during manufacturing and assembly of the touch sensing device or electronic device of which the touch sensing device forms a portion.

In another aspect of the present disclosure, the testing is performed as part of diagnostic operations performed at the electronic device, such as by an end user of the device.

Through testing, an anomaly of the touch sensing device, such as a short circuit or an open circuit, is readily detected. Once detected, the anomaly is alerted, thereby facilitating remedial action, if needed.

In another aspect of the present disclosure, an electrical characteristic sensor is configured to sense an electrical characteristic of the touch sensing device that has a grid formed of a plurality of electrodes. The electrical characteristic, once sensed, permits determination of whether the touch sensing device exhibits an anomaly, such as a short circuit or an open circuit.

In another aspect of the present disclosure, the electrical characteristic that is sensed by the electrical characteristic sensor comprises a capacitance exhibited at an electrode. The capacitance of the electrode is a known quantity. If the sensed value of the capacitance differs with the known-quantity capacitance value, then an anomaly is indicated.

In another aspect of the present disclosure, the electrical characteristic sensed by the electrical sensor comprises a resistance value. If the resistance is negligible, the low resistance is indicative of a short circuit.

In another aspect of the present disclosure, the electrical characteristic sensed by the electrical characteristic sensor comprises a signal of a selected signal value that is applied to a portion of the touch sensing device that is not intended to be connected to any electrode that is undergoing testing. If the electrical characteristic sensor senses the selected signal value, then the detection is indicative of a short circuit at the touch sensing device.

In another aspect of the present disclosure, a touch sensing element anomaly determiner is utilized to determine whether the electrical characteristics sensed by the electrical characteristic sensor is indicative of the anomalous condition. If the sensed, electrical characteristic comprises a capacitance, detection is made of a change in the capacitance from a known capacitance when the touch sensing device is properly configured. If a selected signal value is applied to a portion of the touch sensing device and sensed at another portion of the touch sensing device, the determiner determines if the detection is indicative of a short circuit at the touch sensing device. If the electrical characteristic comprises a resistance, the touch sensing element anomaly determiner determines whether the sensed resistance is indicative of a short circuit, or other anomaly, at the touch sensing device.

In another aspect of the present disclosure, testing is performed during fabrication or assembly of the touch sensing device. For instance, upon completion of the assembly or fabrication, testing is performed to ensure that the touch sensing device has been properly constructed. If testing indicates an anomaly, the identified anomaly is alerted. Remedial actions are then taken.

In another aspect of the present disclosure, testing is performed as part of a diagnostic testing operation of an electronic device. Operation of the diagnostics is, e.g., initiated at the instruction of a user of the electronic device of which the touch sensing device forms a portion. The diagnostics provide an indication of an anomaly at the touch sensing device, indicative of a failed component, i.e., the touch sensing device, at the electronic device.

In these and other aspects, therefore, an apparatus, and an associated method, is provided for testing a touch sensing device. A sensor is configured to sense an electrical characteristic of a sensor-coupled electrode of the touch sensing device. A determiner is configured to determine whether the electrical characteristic is indicative of a touch sensing device anomaly.

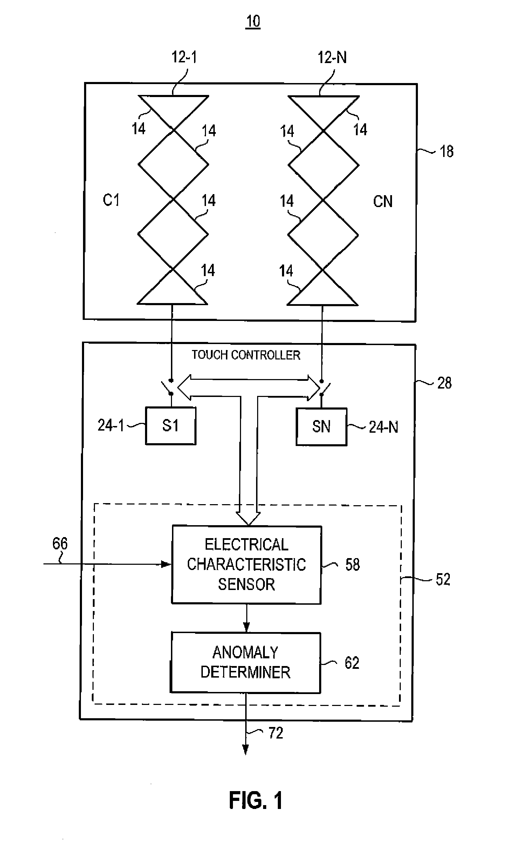

Turning first, therefore, to Figure 1, a touch sensing device 10 provides for the sensing of touch inputs such as touch inputs applied by a user to control operation of, or provide data information to, an electronic device to which the touch sensing device is connected or otherwise forms a portion. The touch sensing device 10 shown in Figure 1 is merely exemplary. In other implementations, the touch sensing device is implemented in other manners, using other types of technologies or configurations.

The touch sensing device 10 includes a plurality of electrodes 12, of which two electrodes 12-1 and 12-N are shown in Figure 1. The electrodes 12 each here include a plurality of electrode portions 14 that are diamond-shape, i.e., rotated, rectangular-shaped, and positioned end-to-end in a lengthwise (as-shown) direction. The shapes of the electrode portions and the relative positioning and orientation of the electrodes are merely exemplary. Many other portion-shapes and electrode arrangements are utilized in other implementations. The electrodes 12 are disposed in layers of a non-conductive material, such as glass or plastic, and the electrodes together with the glass or plastic define a touchscreen 18. The electrodes 12 are electrically isolated from one another and each exhibit a capacitance. The capacitance of the electrode 12-1 is indicated as C1, and the capacitance of the electrodes 12-N is indicated as CN. In the exemplary implementation, the capacitance value C1 and CN are substantially similar to one another as the geometries of the respective electrodes are substantially similar.

The electrodes 12 are each connected to sensors 24, which here form parts of a touch controller 28. Here, a first sensor 24-1 is connected to the electrode 12-1. And, the sensor 24-N is connected to the electrode 12-N. When a touch input is applied to the touch screen 18, the capacitance of one or more of the electrodes is altered, and the alteration in the capacitance is detected by one or more of the sensors 24.

In various implementations, the touch sensing device 10 operates to permit sensing of the capacitance of an entire electrode or capacitance between intersecting electrodes to determine longitudinal and horizontal coordinates of the location at which the touch input is applied. Measurement of the capacitance of an entire electrode is sometimes referred to as a self or projected capacitance measure. And, the measurement of capacitance between intersecting electrodes is sometimes referred to as a mutual or trans- capacitance measure. The touch sensing device 10 is representative of a device capable of self capacitance measurement and mutual capacitance measurement through the appropriate location of the electrodes 12 and sensors 24 of the touch controller 28.

By way of an example, in the configuration shown in Figure 1, a touch input applied to the touch screen 18 forms a capacitance, Cf, which, e.g., is formed of a finger capacitance of a touch input formed by the finger of a user applied to a location on the touch screen. The input capacitance Cf provides for the detection of the input, both the presence of the input and the position touch screen of the input. For instance, if the capacitance C1 changes and the capacitance CN does not change, then a determination is made that the input is applied at the electrode 12-1, and the input is correspondingly interpreted. If, instead, changes in capacitance are noted at both the sensors 24-1 and 24-N, then the input is applied at a location on the touchscreen somewhere between the electrodes 12-1 and 12-N.

As mentioned previously, sensing-device anomalies, such as short circuits between electrodes of the touch sensing device or open circuits, e.g., between an electrode and associated sensor, might be formed during assembly or fabrication of the touch sensing device. Or, an anomaly might develop later, such as subsequent to assembly and fabrication, e.g., subsequent to sale and use by an end user of an electronic device that includes the touch sensing device.

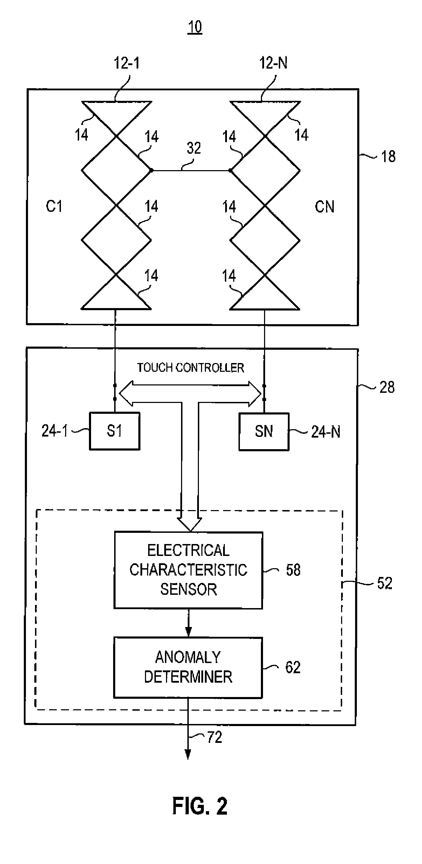

Figure 2 again illustrates the touch sensing device 10, again illustrating the electrodes 12, each formed of portions 14 wherein the electrodes form part of a touchscreen 18. The electrodes are coupled to sensors 24 of a touch controller 28. Here, a short 32 extends between the electrodes 12-1 and 12-N. The capacitance sensed at the sensor 24-1 is not C1. Rather, the capacitance is the sum of the capacitances, i.e., C1 + CN. And, charge flow through this combined capacitance is applied to both the sensors 24-1 and 24-N and is split two. When the sensors 24 are well balanced, the capacitance sensed at the sensor 24-1 is (C1 + CN)/2 and the capacitance sensed at the sensor 24-N is (C1 + CN)/2. If a touch input is applied at the touch screen, the capacitance of the input, Cf, is split equally between the sensors 24-1 and 24-N. And, the sensed location of the touch input always at a midpoint between the electrodes 12-1 and 12-N.

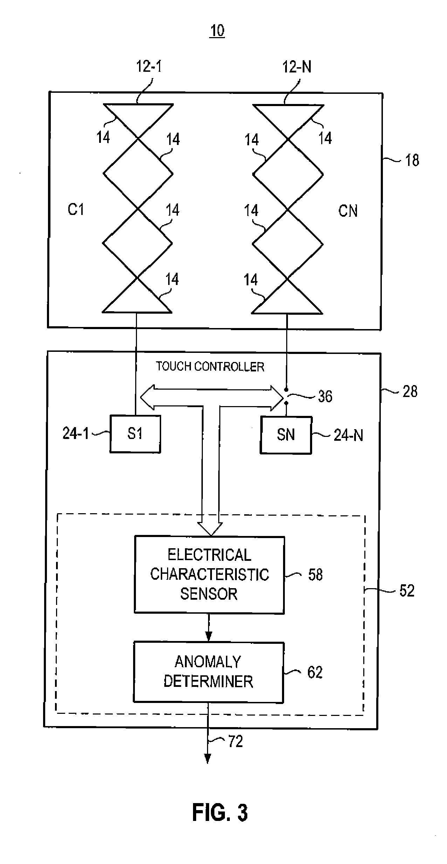

Figure 3 also illustrates the touch sensing device 10 and again illustrates the electrodes 12, each having a plurality of portions 14 with the electrodes configured to form part of a touch screen 18. A touch controller 28 having sensors 24 are also again illustrated.

In this view, an open circuit condition is exhibited. The open circuit 36 separates the sensor 24-N from the electrode 12-N. In this open-circuit condition, the capacitance sensed at the sensor 24-1 is the sum of the capacitances C1 and CN, i.e., C1 + CN.

Turning back again to Figure 1, the touch sensing device 10 further includes an apparatus 52 of an implementation of the present disclosure. The apparatus 52, in the implementation shown in Figure 1, forms part of the touch controller 28. In other implementations, the apparatus 52 is embodied elsewhere, such as a controller of an electronic device of which the touch sensing device 10 forms a portion.

The elements of the apparatus 52 are functionally represented, implementable in any desired manner including, for instance, hardware elements, firmware elements, program code executable by processing circuitry, and combinations thereof. Additionally, the elements of the apparatus are shown to be located together. In other implementations, the elements of the apparatus are distributed cross more than one physical entity or location.

The apparatus 52 is here shown to include, an electrical characteristic sensor 58 and a touch sensing device anomaly determiner 62.

The apparatus 52 facilitates testing of the touch sensing device to test for the presence of short or open circuits that cause malfunctions in the device. Testing is performed at any time, e.g., subsequent to fabrication and assembly of the touch sensing device, e.g., during use by an end-user of the device. Operation of the apparatus commences responsive to external instruction, here provided by way of the line 66, to the electrical characteristic sensor 58. The element 58 operates to cause disconnection of an electrode 12 from an associated sensor 24 and sensing of the electrode.

When testing operations commence, the electrical characteristic sensor 58 causes disconnection out of electrical connection of a sensor 24 and an associated electrode 12. Once disconnected, the electrical characteristic sensor 58 operates to sense a characteristic at the affected location of disconnection caused by the sensor. In one implementation, the sensor 58 senses the capacitance at the location. In another implementation, a resistance is sensed. And in another implementation, presence of a signal value is sensed.

In one implementation, an indication of selection to commence testing generated on the line 66 is provided to the sensor 58. The sensor 58 operates to test for an open circuit, such as the open circuit 36, or analogous open circuit, formed elsewhere at the touch sensing device. An open circuit is identified, for instance, if a capacitance, different than the capacitance expected at the electrode is sensed.

Operation of the sensor 58 to sense an electrical characteristic is a multistep operation, depending upon the characteristic that is to be sensed. When testing is performed to detect presence of a selected signal value, the signal value is first applied to another portion of the touch sensing device, such as at another electrode. And, when resistance is to be sensed, a measuring resistor is added to a circuit including the electrode undergoing testing, and resistance in the electrode is determined by a voltage division analysis across the testing resistor.

The sensed characteristic sensed by the sensor 58 is provided to the anomaly determiner 62. The determiner 62 operates to determine whether the sensed indication, sensed by the sensor 58, indicates an anomalous condition, e.g., an open circuit or a short circuit, at the touch sensing device. An indication of the determination is further generated by the determiner, here indicated by way of the line 72.

An open circuit or broken sensor 24 is detectable by the sensor 58 measuring the capacitance at the electrode. A non-anomalous configuration exhibits a capacitance C1 or CN. If an open circuit or broken sensor condition is exhibited, the sensed capacitance is the sum of the capacitances C1 + CN.

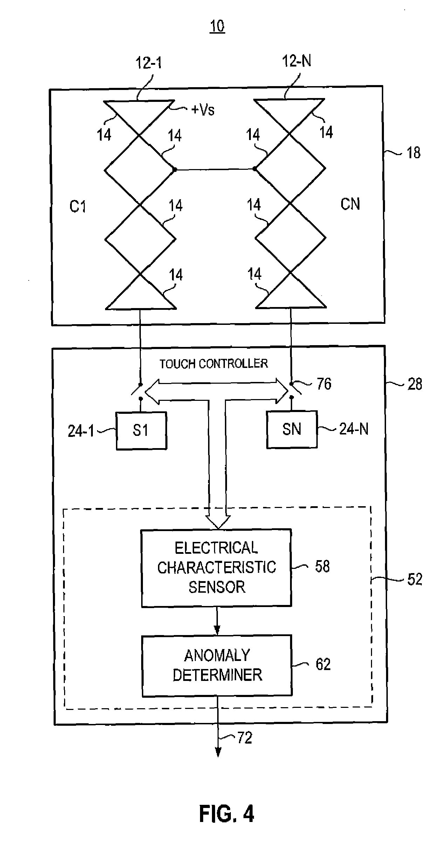

Figure 4 illustrates a portion of the touch sensing device 10 shown in Figures 1-3. The representation shown in Figure 4 illustrates application of a signal value, indicated by Vs applied at the electrode 12-1. In the event that a short circuit is formed between the electrodes 12-1 and 12-N, the signal value Vs is detected at the location 76. Sensing of the signal value at the location 76.

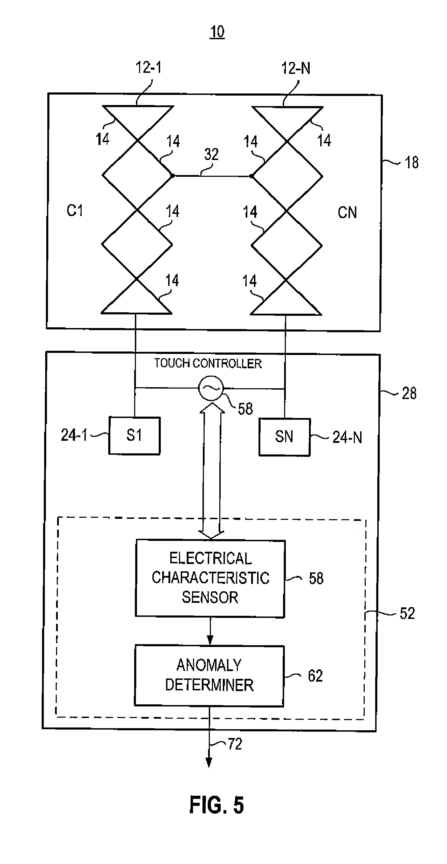

Figure 5 illustrates a representation of a portion of the touch sensing device 10 shown in previous figures, here in which resistance is sensed between electrodes 121 and 12-N. In the illustration of Figure 5, a short circuit 32 extends between the electrodes. And, the sensed resistance sensed by the sensor 58, here configured as an ohm meter, senses nominal or no resistance due to the existence of the short circuit 32.

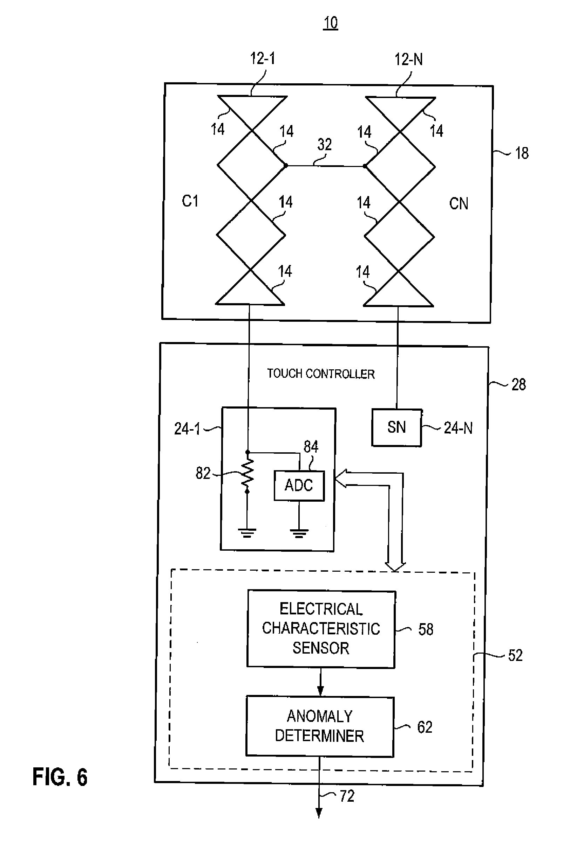

Figure 6 again illustrates a portion of the touch sensing device 10 here in which testing is also performed to sense resistance. In this implementation, a sensor 24 includes a test resistor 82. Voltage across the resistor is detected, here indicated by an analog to digital converter 84. Due to the existence of the short circuit 32, the voltage drop across the resistor 82 is negligible. Such a sensed indication is utilized to determine the existence of an anomaly.

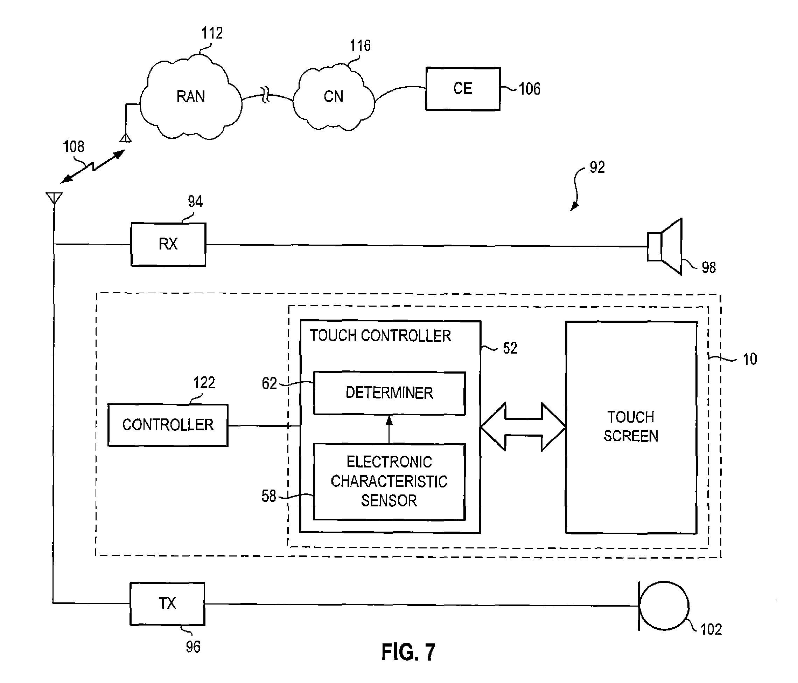

Figure 7 illustrates an exemplary implementation in which a touch sensing device 10 is configured to form part of an electronic device, here a wireless device 92. The wireless device 92 includes transceiver circuitry, represented by a receive (Rx) part 94 and a transmit (Tx) part 96. Transducers 98 and 102 are connected to the receive and transmit parts 94 and 96, respectively.

The wireless device communicates with a communication endpoint (CE) 106 by way of radio channels 108 defined upon a radio air interface extending between the wireless device and a network part, here including a radio access network (RAN) 112 and a core network (CN) 116. The communication endpoint 106 is placed in communication connectivity with the core network 116.

Operation of the device 92 and the touch sensing device 10 that forms a portion of the wireless device is exerted by a controller 122. The controller 122, amongst other things, controls the displays that are displayed at the touch screen of the touch sensing device. The touch sensing device again includes a touch controller 52 having a sensor 58 and a determiner 62.

During operation, the controller controls operation of the wireless device pursuance to communication and, any other functionalities embodied at the device 92. During operation, display screens are displayed at the touch screen, and the user of the device enters touch inputs by way of the touch screen of the touch sensing device.

A user is able to select diagnostic operation at the wireless device to test the operability of the touch screen. An input is entered by way of the touch screen or by way of another input element (not shown), such as a separate switch to invoke the diagnostic testing. Once invoked, testing is carried out as explained previously.

In another implementation, testing is initiated remotely, such as at the communication endpoint 106. The instruction to invoke the diagnostic testing is routed through the network part, sent upon radio channels 108, delivered to the wireless device 92, detected by the receive part 94, and provided to the apparatus 52 of the touch sensing device to invoke the diagnostic testing. Testing is performed as described previously.

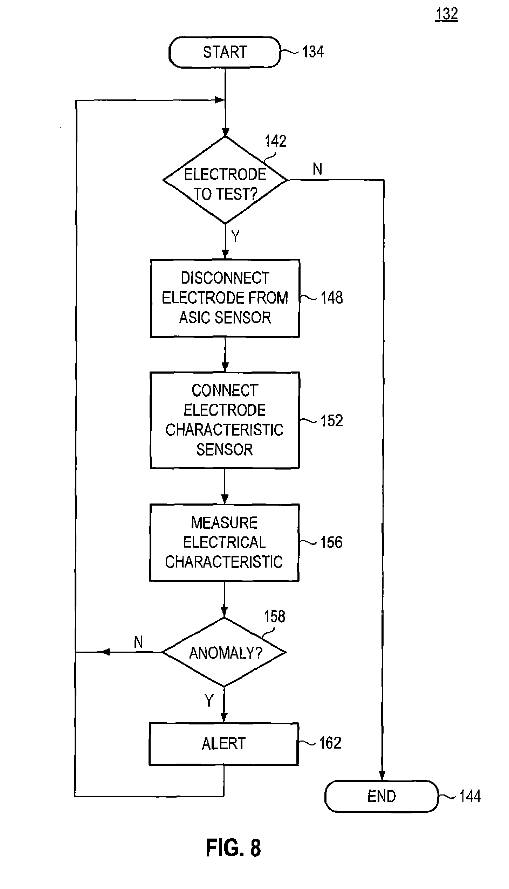

Figure 8 illustrates a process 132 of testing for anomalies at a touch sensing device, such as the touch sensing device 10 shown in previous figures. Anomalies for which testing is performed include, e.g., the presence of short circuit or open circuits.

The process commences at the start block 134. At the decision block 142, a determination is made as to whether an electrode of the touch sensing device remains to be tested. In this exemplary process, each of the plurality of electrodes of the touch sensing device are tested. The sequence of testing of the electrodes is carried out in any of various manners, e.g., testing is performed of electrodes starting with a left-most electrode, a right-most electrode, a top-positioned electrode, a bottom positioned electrode, a center-positioned electrode, by sequencing in a clockwise, or counter clockwise direction of radially-configured electrodes etc. In one implementation, the process 132 further includes a selection of the testing sequence. If no electrodes remain to be tested, the no branch is taken to the end block 144.

If, conversely, an electrode is to be tested, the yes branch is taken to the block 148, and the electrode is disconnected from the associated sensor of the touch controller. Then, and as indicated by the block 152, a sensor is connected to sense for an electrical characteristic. And, as indicated by the block 156, the electrical characteristic is measured.

An indication of the measured characteristic is utilized to determine, as indicated at the decision block 158, a determination is made as to whether the measured characteristic indicates an anomaly, such as a short circuit or an open circuit. If so, the yes branch is taken to the block 162, and an alert is generated to annunciate the detected presence of an anomaly. If no anomaly has been detected, the no branch is taken from the decision block 158 back to the decision block 142. Thereby, the process iterates through the electrodes to test each electrode of the touch sensing device.

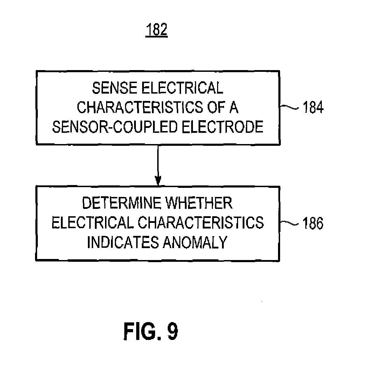

Figure 9 illustrates a method 182 representative of the method of operation of an implementation of the present disclosure. The method facilitates testing of a touch sensing device. First, and as indicated by the block 184, an electrical characteristic of a sensor-coupled electrode of the touch sensing device is sensed. Then, and as indicated by the block 188, a determination is made as to whether the electrical characteristic that is sensed is indicative of a touch sending device anomaly.

Thereby, a manner is provided by which easily to test for anomalies in a touch sensing device, either during assembling and fabrication of the device or subsequent to incorporation of the touch sensing device into an electronic device.

Presently preferred implementations of the disclosure and many of improvements and advantages thereof have been described with a degree of particularity. The description is of preferred examples of implementing the disclosure, and the description of examples is not necessarily intended to limit the scope of the disclosure. The scope of the disclosure is defined by the following claims.

## Claims

1. A method for testing a touch sensing device, said method comprising:
sensing an electrical characteristic of a sensor-coupled electrode of the touch sensing device; and
determining whether the electrical characteristic sensed during said sensing is indicative of a touch sensing device anomaly.

2. The method of claim 1 further comprising generating an alert if determination is made during said determining that the electrical characteristic is indicative of a touch sensing device anomaly.

3. The method of claim 2 wherein the touch sensing device forms part of an electronic device and wherein said sensing and said determining are pursuant to self-diagnosis at the electronic device.

4. The method of claim 1 wherein said sensing comprises sensing capacitance at the sensor-coupled electrode.

5. The method of claim 1 wherein said sensing comprises sensing a resistance at the sensor-coupled electrode.

6. The method of claim 1 further comprising applying a selected signal value to a portion of the touch sensing device and wherein said sensing comprises detecting whether the selected signal value is present at the sensor-coupled electrode of the touch sensing device.

7. The method of claim 6 wherein the sensor-coupled electrode comprises a first sensor-coupled electrode of a grid formed of a plurality of sensor-coupled electrodes and wherein said applying a selected signal value to a portion of the touch sensing device comprises applying a selected signal value to a second sensor-coupled electrode of the plurality of sensor-coupled electrodes.

8. The method of claim 7 wherein the first sensor-coupled electrode is connectable to a first sensor and wherein the second sensor-coupled electrode is connectable to a second sensor, said method further comprising, prior to said applying the selected signal value to the second sensor-coupled electrode, disconnecting the second sensor-coupled electrode from the second sensor.

9. The method of claim 7 wherein said applying the selected signal value comprises applying a logical-high-valued voltage to the second sensor-coupled electrode.

10. The method of claim 1 wherein said determining comprises determining whether the electrical characteristic sensed during said sensing is indicative of a short circuit at the touch sensing device.

11. The method of claim 1 wherein said determining comprises determining whether the electrical characteristic sensed during said sensing is indicative of an open circuit at the touch sensing device.

12. An apparatus for facilitating testing of a touch sensing element of an electronic device, said apparatus comprising:
an electrical characteristic sensor configured to sense an electrical characteristic of the touch sensing element responsive to detection of selection to test the touch sensing element; and
a touch sensing element anomaly determiner configured to determine, responsive to the electrical characteristic sensed by said electrical characteristic sensor, whether the touch screen element exhibits an anomaly.

13. The apparatus of claim 12 wherein said electrical characteristic sensor is configured to sense an electrical characteristic of the touch-sensing element responsive to manual detection of selection to test the touch sensing element.

14. The apparatus of claim 12 wherein said touch sensing element anomaly determiner is further configured to generate an indication when the touch screen element exhibits the anomaly.

15. The apparatus of claim 12 wherein said electrical characteristic sensor is configured to sense a capacitance of the touch sensing element.
